(19) **Europäisches Patentamt**

**European Patent Office**

**Office européen des brevets**

(11) **EP 0 930 549 A1**

(12) **EUROPEAN PATENT APPLICATION**

(43) Date of publication:
21.07.1999 Bulletin 1999/29

(51) Int. Cl.$^6$: **G03H 1/00**, G02B 5/18,
G02B 27/10

(21) Application number: 98300188.4

(22) Date of filing: 13.01.1998

(84) Designated Contracting States:
**AT BE CH DE DK ES FI FR GB GR IE IT LI LU MC
NL PT SE**
Designated Extension States:
**AL LT LV MK RO SI**

(71) Applicant:
**HOLTRONIC TECHNOLOGIES LIMITED
London EC4A 1NH (GB)**

(72) Inventors:
• **Han, Woosung**
2074 Marin (CH)
• **Carnal, Olivier Henri**
2074 Marin (CH)

(74) Representative:
**Riederer, Conrad A., Dr. et al
c/o Riederer Hasler & Partner
Patentanwälte AG
Bahnhofstrasse 10
7310 Bad Ragaz (CH)**

(54) **Optic for a total internal reflection (TIR) holographic system**

(57) The present invention relates to an optic, in particular for use as optic in a total internal reflection (TIR) holographic system, a TIR apparatus and a process using such an optic. The optic comprises a plate (23) which has essentially flat first and second surfaces. It is of a material being transparent for the light used in the lithographic process and has a periodic grating structure (25,37) on the first surface whose period, in relation to the incident angle and wavelength of the light and the refractive index of the plate material, is such that only a zeroth (33) and one first order beams (29) of the light (27) being incident on the first surface at a predetermined incident angle ($\theta_4$) are transmitted into the plate (23) and the transmitted first diffraction order (29) is essentially totally reflected at the second surface/air interface.

FIG. 3

## Description

The present invention relates to an optic, in particular for use as optic in a total internal reflection (TIR) holographic system.

The principles of total internal reflection (TIR) holography have been described already in 1970 in US 3,551,018 by K.A. Stetson. Since then many efforts have been made to make use of TIR holography in the microelectronics industries. Prior art references are e.g. US 4,857,425, US 4,917,497, US 4,966,428, 5,187,372, US 5,640,257 whose contents are herewith incorporated by reference.

A principal component of the TIR holographic systems presently used in the art is a prism which corresponds to the projection optics in optical steppers and scanners. Since TIR holography uses only one prism as a primary optic, a lithographic tool using this technique is much simpler than conventional optical steppers having a great number of lenses which are of large size and, accordingly, difficult and expensive to manufacture. Another advantage of total internal reflection holography is related to the very small gap, typically between 50 and 200 $\mu$m, between the hologram and the wafer to be printed which enable a large effective numerical aperture and large field size.

The prisms usually used in TIR holography for processing 5 inch or larger substrates weigh several kilograms. As the handling of such heavy prisms is inconvenient the photosensitive material is not applied directly to one of the prism surfaces but onto a separate plate which is then optically contacted to one of the prism surfaces. The use of separate plates offers the advantage that the plates can be easily processed by existing equipment. The matching liquid is selected such that it exhibits the same refractive index as the prism and the glass plate. As the manufacture of electronic devices usually requires the deposition of many layers of conductive and semi-conductive materials, one and the same wafer has to be exposed many times in the TIR lithographic system. Each time when a new pattern has to be printed on the wafer a corresponding new hologram has to be attached to the prism. A disadvantage of this procedure is that the exchange and the matching of the hologram bearing plate to a prism is an inconvenient procedure. A further disadvantage is that the interchange of holograms mounted to different prisms in the holographic equipment requires a inconvenient mechanical system. A still further disadvantage is that they can occupy a large space in the production facilities.

The appliance of the photosensitive material directly on one of the prism surfaces has never been used so far as, in practice, it is difficult to achieve a uniform coating of the material on the prism surface. Further, it is not convenient to process, i.e. develop, etch etc., the image if the same is directly connected with the prism as this would require new processing equipment.

It is an object of the present invention to improve the optic of known total internal reflection (TIR) holographic systems in a sense that it becomes more manageable and more compact. A further object is to provide a coupling optic which can easily be attached to a substrate. A still further object is to provide an optic which can also function as support or substrate of a recording medium or hologram.

According to the invention there is provided a plate having essentially flat first and second surfaces and of a material being transparent for the light used in the lithographic system or process, respectively, the plate having a periodic grating structure on the first surface whose period, in relation to the incident angle and wavelength of the light and the refractive index of the plate material is such that only a zeroth and one first order beams of the light being incident on the first surface at a predetermined incident angle ($\theta_4$) are transmitted into the plate and that the transmitted first diffraction order is essentially totally reflected at the second surface/air interface. The inventive optic in the form of e.g. a grating backed glass plate has the advantage that it can replace the conventional prisms used so far in TIR holography as primary optic. The grating backed glass plate is light and can therefore be easily handled and processed. The optical plate can be used just as optic which is attached to a substrate bearing a recording medium or a hologram, or it can receive the recording medium or the hologram directly on the preferably plane second surface opposite to the grating bearing parallel first surface. In the latter case the optic functions also as support or substrate for the recording medium or hologram, respectively. Preferably, the depth to pitch ratio and profile of the periodic structure are such that the intensity of the transmitted first diffraction order is large in comparison with that of the transmitted zeroth diffraction order.

In order that the optic can be used as primary optic it needs to be transparent for the exposure light or electromagnetic radiation used for illuminating the recording layer or the hologram. Preferably the substrate is made from a transparent or glass-like material or from glass having preferably a refractive index of greater than about 1.4, preferably about 1.4 to 1.6 which is typical for glass, and a depth to pitch ratio in the range between 1.0 and 3.0. For light of a wavelength of 140 and 500 nm the incident angle can vary between 40 and 80°, preferably between 50 and 75°. The pitch in absolute terms can be in the range of 250 to 60 nm, preferably between 200 and 80 nm.

The grating structure can be of a sawtooth or square or any other profile. Preferably, for an incident light beam of wavelength 364 nm, a refractive index of about 1.4 to 1.6 of the plate material and a square profile of the grating structure, the depth to pitch ratio of the grating structure is in the range between 1.0 and 2.0 and preferably between 1.35 and 1.7, and the incident angle of the light beam is between 55 and 80°, preferably between 58 and 75°, and most preferably at about 60 to 72°. For the above parameters the pitch in absolute terms preferably ranges between 200 nm to 166 nm, preferably between 197 nm and 175 nm, and most preferably is about 185 nm.

Preferably, for an incident light beam of wavelength 364 nm, a refractive index of about 1.4 to 1.6 and a grating structure of a sawtooth profile, the depth to pitch ratio of the grating structure is in the range between 1.4 and 3.0, preferably between 2.8 and 2.0, and the incident angle is between 35 and 75°, preferably between 47 and 65°, and most preferably at about 55 to 63°. For a sawtooth profile and by using light of 364 nm the pitch in absolute terms can range between 270 nm to 180 nm and preferably lies between 230 nm and 182 nm, and most preferably is about 192 nm.

Exemplified embodiments of the invention are described below with reference to the drawings, wherein

Fig.1    shows schematically the principle of total internal reflection holography for recording a mask pattern by way of a known TIR holographic system;

Fig.2    shows schematically the reconstruction of the hologram;

Fig.3    shows an embodiment of an optic according to the invention in the form of a transparent plate having a grating structure on one surface;

Fig. 4    shows the diffraction efficiency as a function of the incident angle of light of 364 nm for different depth/pitch ratios of the grating which results in a 45° deflection of the first order light;

Fig. 5    shows the grating pitch as a function of the incident angle of light of 364 nm for the grating structure of Fig. 4;

Figs. 6,7    show the same graphs as in Fig. 4 and 5 but for a sawtooth grating structure;

Fig. 8    shows the sawtooth grating structure being the basis for the simulation of Figs. 6 and 7;

Fig. 9    shows schematically the recording of a pattern (not shown) in a recording layer of a substrate which is attached to an optic according to the invention;

Fig. 10    shows schematically the reconstruction of a hologram formed on a substrate which is attached to an optic according to the invention;

Fig. 11    shows schematically the recording of a pattern (not shown) in a recording layer of a substrate having a grating formed directly on its backside;

Fig. 12    shows schematically the reconstruction of a hologram from the substrate of Fig. 10.

The principle of total internal reflection (TIR) follows from Snell's equation ($n_1 * \sin \theta_1 = n_2 * \sin \theta_2$) which says that a light beam which passes obliquely from a medium of a higher refractive index ($n_1$) into a medium of a lower refractive index ($n_2$) is totally reflected at the interface of the two media if the angle of the incident light beam exceeds a certain value, the so-called critical angle. In the case of the media glass ($n_1 \cong 1.5$) and air ($n_2 = 1$) the critical angle is approx. 41.5°.

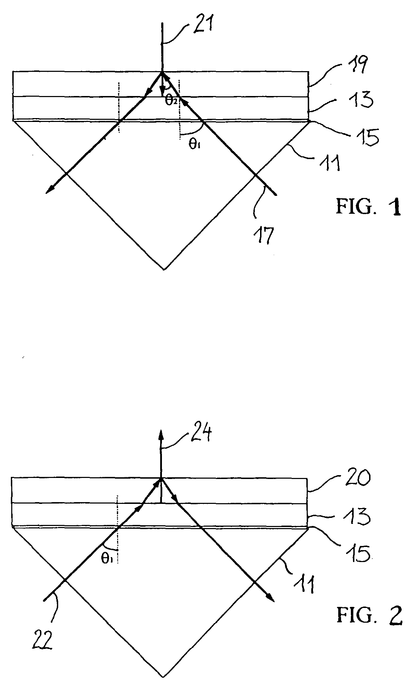

An essential component of each hitherto known TIR holographic system is a prism 11 (Fig. 1 and 2). On said prism 11 a first substrate 13 being coated with a holographic recording layer 19 is index-matched by means of an appropriate matching fluid 15 (Fig. 1). In the drawings the thicknesses of the layers do not correspond to the actual values, i.e. the thickness of the recording layer 19 normally is much less thick than the substrate 13. The matching fluid 15 is chosen such that it exhibits the same refractive index as the prism material so that a light beam 17 which passes from the prism 11 into the substrate 13 is not further refracted at the prism/substrate interface. Provided the hologram recording layer exhibits a smaller or greater refractive than the substrate material, then the light beam 17 will be refracted at the interface between the substrate 13 and the holographic recording layer ($\theta_2$). This refraction has no influence on the hologram formig process as long as the condition for total internal reflection is fulfilled. Total internal reflection occurs at the interface between the holographic layer 19 and the ambient air if the angle $\theta_1$ of the incident light beam 17 is greater than the critical angle (Fig. 1). As the possible refraction between the substrate 13 and the recording medium 19 has no impact on the present invention, said refraction will not be further discussed in the following description.

For recording a hologram, a mask pattern (not shown in Fig. 1), containing e.g. an integrated circuit pattern, is placed parallel and in proximity to the first substrate 13. Thereafter the pattern of the integrated circuit is holographically recorded in the recording layer 19 of the first substrate 13 by illuminating said recording layer 19 with an object beam 21 and the reference beam 17 of mutually coherent light, the object beam 21 passing through the mask window and being incident on the recording layer 19 at 90°, and the reference beam being projected through one of the shorter faces of the prism 11 at such an angle that the light beam is totally internally reflected at the photosensitive layer/air interface.

The interference between the object and the reference beams 17,21 is recorded in the photosensitive or recording layer 19 to form a hologram which is designated with reference numeral 20 in Fig. 2.

For reconstructing the hologram 20, the hologram bearing substrate 13 is again index-matched to the prism face and, instead of the mask, a second substrate, e.g. a silicon wafer (not shown in Fig. 2) being coated with a photosensitive layer, is placed parallel and in proximity to the hologram 20 bearing first substrate 13 (Fig. 2). Thereafter a so-called reconstruction beam 22 is directed through the prism 11 in the exactly reversed direction (angle $\theta_1$) to the reference beam 17 previously used for the hologram recording. In practice, the hologram usually is rotated 180° about its axis so that the reference beam 17 functions as reconstruction beam. The reconstruction beam 22 produces a positive image of the circuit pattern in the photosensitive layer of the silicon wafer (light beam 24).

In the subsequent figures like elements are designated with like reference numerals as in the previous description of figures 1 and 2.

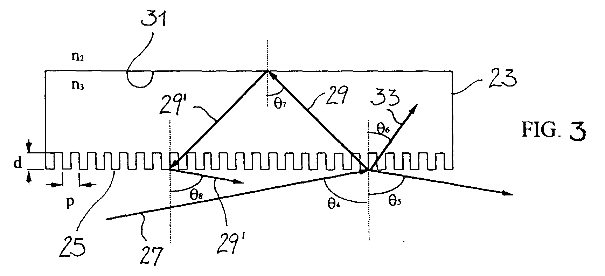

According to the invention there is provided an optic in the form of a flat transparent object or plate 23 having a high transmission coefficient for the light being used in the holographic process and having a periodic grating structure 25 formed on one surface of the plate 23 (Fig. 3). Such a grating backed plate 23, as will be explained hereinafter, can replace the prism 11 of conventional TIR holographic systems.

As shown in Fig. 3 a light beam 27 being incident on the grating structure 25 at an angle $\theta_4$ will be diffracted so that the transmitted first order beam 29 impinges on the opposite internal surface 31 at an angle $\theta_7$ being greater than the critical angle. The totally reflected light beam 29' then escapes from the plate 23 through grating structure 25 at an angle $\theta_8$. The zero order light beam 33 however is deflected by the grating structure 25 to the internal surface 31 at an angle $\theta_6$.

The relationship among the angles $\theta_4$ to $\theta_8$ is as follows:

1. $\theta_4 = \theta_5 = \theta_8$. This relationship follows directly from law of reflection.
2. $\theta_6$ is defined by Snell's equation: $n_2 *\sin \theta_4 = n_3 *\sin \theta_6$ wherein $n_2$ and $n_3$ are the refractive indices for air and the plate material, respectively, and $\theta_4$ is chosen such that the best transmitting first order diffraction efficiency, or an acceptably high diffraction efficiency, can be obtained in conjunction with the grating structure used. The grating structure 25 is defined by its grating depth to pitch ratio (d/p) and the profile or shape of the grating.
3. The relationship between $\theta_4$ and p is calculated for a specific grating shape based on the grating equation:

$$n_2 *\sin \theta_4 + n_3 *\sin \theta_7 = \lambda/p,$$

wherein $\lambda$ is the free space wavelength of the beam 27.

In the above equation all parameters except $\theta_4$ and the pitch p are known ($\theta_7$ is set to 45° which is greater than the critical angle and $\lambda$ corresponds to wavelength of the light source used).

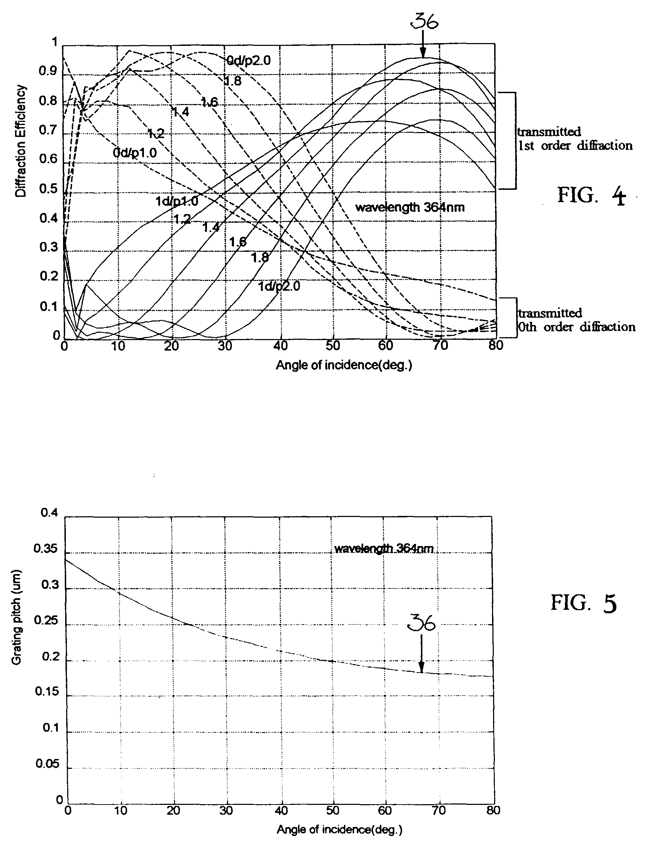

Fig. 4 and 5 show the simulation results obtained for the unknown parameters d,p and $\theta_4$ when $\theta_7 = 45°$, $\lambda = 364$ nm and the grating structure has a square profile. The simulations were performed by applying the numerical calculations disclosed by M.G. Moharam and T.K. Gaylord in Opt. Soc. Am., 72 (10), pp. 1385-1392 (1982) under the title "Diffraction analysis of dielectric surface-relief gratings". Another solution which produces the same results was published by R.H. Morf in Opt. Soc. Am., A12 (5), pp. 1043-1056 (1995) under the title "Exponentially convergent and numerically efficient solution of Maxwell's equations for lamellar gratings". The aforementioned two references are herewith incorporated by reference.

As it can be seen from Fig. 4 and 5, the transmitted first order efficiencies (solid lines) are higher than the transmitted zero order efficiencies (dashed lines) as long as the incident angle of beam 27 is higher than 50°. The highest transmitted first order efficiency (96%) is found at an incident angle of 67° at a depth to pitch ratio (d/p) of 1.4 where only a small fraction ($\cong 1\%$) of the transmitted zero order light is observed. The remaining 3% of the light intensity is reflected off the grating surface (light beam 35 in Fig. 4). It further follows from the above calculations that at an angle of 67° the grating pitch p should be as small as about 185 nm (see arrow 36 in Figs. 4 and 5).

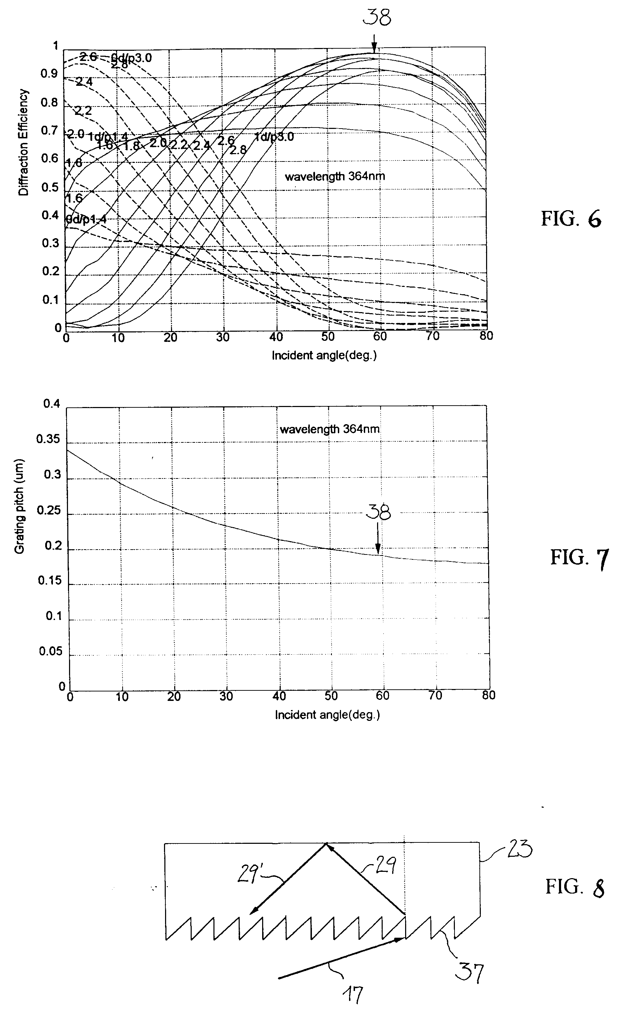

Similar simulations can be done for different grating shapes, e.g. a sawtooth profile 37 (Fig. 6 to 8). For the sawtooth profile 37 the highest efficiency of transmitted first order light is found at an incident angle of 58° for a depth to pitch ratio (d/p) of 2.4. The optimum pitch of the grating thereby is as small as 192 nm (see arrow 38 in Figs. 6 and 7).

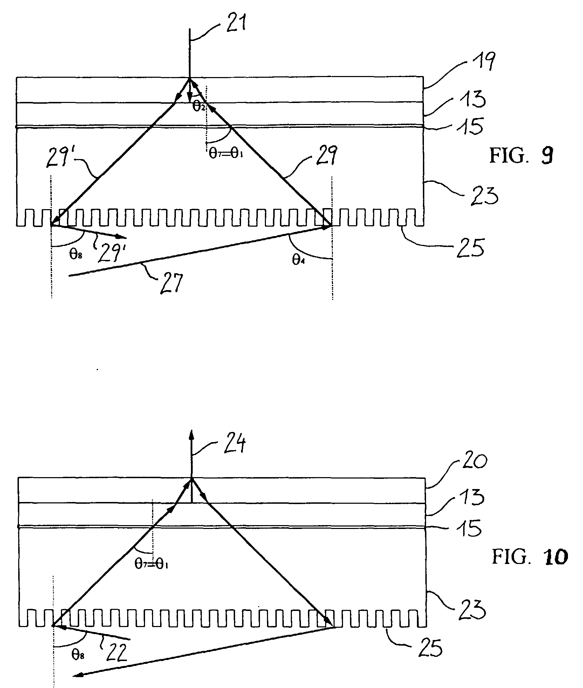

Fig. 9 and 10 show the use of a glass plate 23 having a grating structure on one surface as primary optic to which a substrate 13 of preferably the same refractive index is optically contacted. The grating backed glass plate 23 replaces the prism 11 of hitherto known TIR holographic systems as shown in Figures 1 and 2.

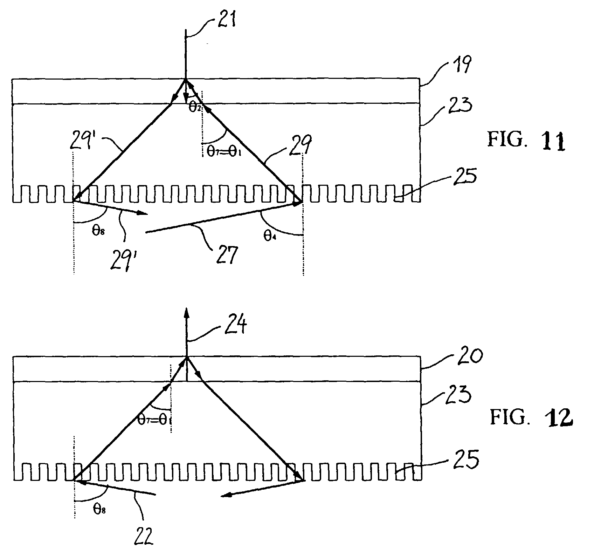

The optic according to the invention allows to coat the recording layer 19 directly onto the grating backed glass plate 23 (Fig. 11 and 12). Substrates having a grating structure 25,37 on one surface and a hologram or holographic recording layer on the other surface can be processed in the same manner and in existing apparatus as conventional substrates. Grating backed substrates have the advantage that there is no longer a need for an indexing fluid for matching the substrate to the optic like in the known TIR holographic systems (compare Figures 1 and 2). This means that the manufacturing process using the inventive optic becomes faster and the risk that the surfaces are deteriorated by attaching the substrate to and detaching it from the primary optic is eliminated.

Simulations can also be performed for other, e.g. smaller, wavelengths. It can be shown that the maximum of the transmitted first order light is not essentially shifted and that also the incident angle is about the same when light of = 257 nm instead of 364 nm is used. By using light of 257 nm the pitch of the grating should be as small as 130 nm for a square profile.

It will be appreciated by a skilled person that the present invention offers significant advantages over hitherto known optics of holographic systems. The grating coupled TIR holography allows an easier handling and processing of the substrates, in particular when the grating structure 25,37 is formed directly on the backside of the substrate, i.e. the substrate or support for the recording layer 19 or hologram 20 is the primary optic at the same time. It is also possible to form the grating 25,37 on a foil which can be attached to the backside of the substrate. As grating backed substrates are much less expensive than known prisms it is possible to use a plurality of such grating backed plates and to automate the exposure, developing etc. process for making multi-layered electronic devices such as integrated circuits. The material of the substrate can be any which is essentially transparent for the light to be used in the exposure process. The periodic grating structure can be manufactured by any lithographic methods such as optical, electron-beam, ion beam, x-ray, holography, AFM etc. The grating backed plates can be used many times. The invention is neither limited to any specific grating structure nor to a specific wavelength nor to a specific substrate material. The angle of the incident light beam and the optimum depth to pitch ratio as well as the pitch in absolute terms can be calculated for a determined grating profile, wavelength and determined refractive indices according to known algorithms.

## Claims

1. An optic, in particular for use as optic in a total internal reflection (TIR) holographic system, for coupling light incident on the optic at a predetermined incident angle, comprising a plate (23) having essentially flat first and second surfaces and of a material being transparent for the light used in the lithographic system or process, respectively, the plate (23) having a periodic grating structure (25,37) on the first surface whose period, in relation to the incident angle and wavelength of the light and the refractive index of the plate material is such that only a zeroth (33) and one first order beams (29) of the light (27) being incident on the first surface at a predetermined incident angle ($\theta_4$) are transmitted into the plate (23) and that the transmitted first diffraction order (29) is essentially totally reflected at the second surface/air interface.

2. An optic according to clam 1 wherein the depth to pitch ratio and profile of the periodic structure are such that the intensity of the transmitted first diffraction order (29) is large in comparison with that of the transmitted zeroth diffraction order (33).

3. An optic according to claim 1 or 2, characterized in that for a refractive index of the plate (23) of about 1.4 to 1.6 the depth to pitch ratio (d/p) of the grating structure (25,37) is in the range between 1.0 and 3.0.

4. An optic according to any of the preceding claims 1 to 3, wherein for a wavelength of the light in the range between 140 nm and 500 nm the incident angle varies between 40 and 80°, preferably between 50 and 75°.

5. Optic according to any of the preceding claims 1 to 3, characterized in that for an incident light beam of wavelength 364 nm, a refractive index of about 1.4 to 1.6 of the plate (23) and a square profile (25) of the grating structure, the depth to pitch ratio of the grating structure is in the range between 1.0 and 2.0 and preferably between 1.35 and 1.7, and the incident angle of the light beam is between 55 and 80°, preferably between 58 and 75°, and most preferably at about 60 to 72°.

6. Optic according to any of the preceding claims 1 to 3, characterized in that for an incident light beam of wavelength 364 nm, a refractive index of about 1.4 to 1.6 and a grating structure of a sawtooth profile, the depth to pitch ratio of the grating structure is in the range between 1.4 and 3.0 and preferably between 2.8 and 2.0, and the incident angle is between 35 and 75°, preferably between 47 and 65°, and most preferably at about 55 to 63°.

7. Total Internal Reflection (TIR) holographic apparatus comprising

   - an optic (23) according to any of the preceding claims 1 to 5;
   - at least one light source emitting light of a certain wavelength for generating a reference beam (27)
   - means for directing the reference beam (27) to the grating structure bearing first surface of the optic (23) such that the reference beam (27) is totally reflected at the second surface/air interface.

8. The apparatus according to claim 7 characterized in that it further comprises

    - beam splitting means for generating an object beam (21) and a reference beam (27); and
    - means for directing the object beam (21) to the optic (23) at substantially normal incidence.

9. Use of an optic according to any of the preceding claims 1 to 5 in a total internal reflection holographic system.

10. Total internal reflection holographic process wherein light is directed to a holographic recording layer such that it traverses the layer and is then essentially totally reflected off the holographic recording layer/air interface characterized in that the holographic recording layer is applied directly on the second surface of an optic according to any of the preceding claims 1 to 6 and that the light is directed to the first surface such that only a zeroth (33) and one first order beams (29) of the light (27) being incident on the first surface at a predetermined incident angle ($\theta_4$) are transmitted into the plate (23).

11. Total internal reflection holographic process wherein light is directed to a holographic recording layer such that it traverses the layer and is then essentially totally reflected off the holographic recording layer/air interface characterized in that the holographic recording layer is applied on a transparent substrate which is then optically coupled to the second surface of an optic according to any of the preceding claims 1 to 6 and that the light is directed to the first surface such that only a zeroth (33) and one first order beams (29) of the light (27) being incident on the first surface at a predetermined incident angle ($\theta_4$) are transmitted into the plate (23).

FIG. 1

FIG. 2

FIG. 3

FIG. 4

FIG. 5

FIG. 6

FIG. 7

FIG. 8

FIG. 9

FIG. 10

FIG. 11

FIG. 12

**European Patent Office**

**EUROPEAN SEARCH REPORT**

Application Number

EP 98 30 0188

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 4 215 924 A (MATSUMOTO KAZUYA) 5 August 1980<br>* column 11, line 61 - line 66 *<br>* figure 23 * | 1 | G03H1/00<br>G02B5/18<br>G02B27/10 |
| A | | 7,10,11 | |
| X | WO 81 03551 A (OPTISK FORSKNING INST ;AHLEN H (SE)) 10 December 1981<br>* page 7, line 13 - page 9, line 3 *<br>* figures 1,3 * | 1 | |
| A | | 7,10,11 | |
| X | US 4 711 512 A (UPATNIEKS JURIS) 8 December 1987<br>* column 2, line 20 - line 47 *<br>* figure 1 * | 1 | |
| A | PATENT ABSTRACTS OF JAPAN<br>vol. 016, no. 075 (P-1316), 24 February 1992<br>& JP 03 265883 A (TOPPAN PRINTING CO LTD), 26 November 1991,<br>* abstract * | 1,7,10,11 | |
| D,A | US 4 966 428 A (PHILLIPS NICHOLAS J) 30 October 1990<br>* column 2, line 30 - line 66 *<br>* figure 1 * | 1,7,10,11 | |

TECHNICAL FIELDS SEARCHED (Int.Cl.6)

G02B

The present search report has been drawn up for all claims

| Place of search | Date of completion of the search | Examiner |
|---|---|---|
| THE HAGUE | 9 June 1998 | Krametz, E |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)